# EUROPEAN PATENT APPLICATION

(11) **EP 4 645 386 A1**
(43) Date of publication of application: **05.11.2025**
(21) Application number: 24174054.7
(22) Date of filing: 03.05.2024
(51) Int. Cl.: H01L 23/498

(54) **TRANSISTOR PACKAGE WITH AREAL INTERNAL INTERCONNECT**

(71) Applicant: Infineon Technologies Austria AG, 9500 Villach (AT)
(72) Inventor: HEITZER, Ludwig, 94350 Falkenfels (DE); IRRGANG, Christian, 93161 Sinzing (DE); MEYER, Thorsten, 93053 Regensburg (DE); ZHUANG, Hao, 85662 Hohenbrunn (DE)
(74) Representative: Lambsdorff & Lange Patentanwälte Partnerschaft mbB

(57) **Abstract**

A semiconductor chip package includes a semiconductor transistor chip having a first side and a second side opposite the first side. The first side includes first load current chip pads and second load current chip pads. An interconnect substrate comprises a first metal layer, a second metal layer and an insulating material disposed between the first metal layer and the second metal layer. The first metal layer includes a pattern of holes, the second metal layer includes a pattern of protrusions, and the protrusions pass through the holes. The semiconductor transistor chip is mounted on the interconnect substrate with the first side facing the interconnect substrate. The first metal layer is connected to a plurality of the first load current chip pads and the second metal layer is connected via the pattern of protrusions to a plurality of the second load current chip pads.

## Description

### Technical Field

This disclosure relates generally to the technique of semiconductor packaging, and in particular to semiconductor transistor chip packaging using an optimized internal interconnect.

### Background

Packaging techniques can have a high impact on device performance. Packaging concepts may aim to provide a high routing capability, a high variability of footprint design, a good board level reliability (e.g., high thermal cycling on board (TCoB) performance) and good thermal dissipation into the board and/or to a heat sink as well as low assembly cost.

Moreover, in particular for power applications, the R_{DS(on)} of transistor products are one of the main parameters for the performance of power transistor devices. For the final product the match between the chip resistance and the package resistance is important to offer a device with a minimum power loss and a maximum performance. Especially for wide band gap (WBG) applications like GaN or SiC, a high chip-package performance is important and very short and/or low resistance current paths are needed.

### Summary

According to an aspect of the disclosure, a semiconductor chip package includes a semiconductor transistor chip having a first side and a second side opposite the first side. The first side includes first load current chip pads and second load current chip pads. An interconnect substrate comprises a first metal layer, a second metal layer and an insulating material disposed between the first metal layer and the second metal layer. The first metal layer includes a pattern of holes, the second metal layer includes a pattern of protrusions, and the protrusions pass through the holes. The semiconductor transistor chip is mounted on the interconnect substrate with the first side facing the interconnect substrate. The first metal layer is connected to a plurality of the first load current chip pads and the second metal layer is connected via the pattern of protrusions to a plurality of the second load current chip pads.

According to another aspect of the disclosure, a method of manufacturing a semiconductor chip package includes providing an interconnect substrate comprising a first metal layer, a second metal layer and an insulating material disposed between the first metal layer and the second metal layer. The first metal layer includes a pattern of holes, the second metal layer includes a pattern of protrusions, and the protrusions pass through the holes. The method comprises providing a semiconductor transistor chip having a first side and a second side opposite the first side, wherein the first side comprises first load current chip pads and second load current chip pads. The method further comprises mounting the semiconductor transistor chip on the interconnect substrate with the first side facing the interconnect substrate, wherein the first metal layer is connected to a plurality of the first load current chip pads and the second metal layer is connected via the pattern of protrusions to a plurality of the second load current chip pads.

### Brief description of the drawings

In the drawings, like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1 is a cross sectional view of an example of a semiconductor chip package.
Figure 2 is a perspective top view on an example of an interconnect substrate having a first and a second metal layer, wherein the insulating material of the interconnect substrate is not shown.
Figure 3 is a perspective bottom view (footprint) on an example of an interconnect substrate having a first and a second metal layer, wherein the insulating material of the interconnect substrate is not shown.
Figure 4 is a perspective top view on an example of an interconnect substrate having a first, a second and a third metal layer, wherein the insulating material of the interconnect substrate is not shown.
Figure 5 is a perspective bottom view (footprint) on an example of an interconnect substrate having a first, a second and a third metal layer, wherein the insulating material of the interconnect substrate is not shown.
Figure 6 is a side view of an example of an interconnect substrate having a first, a second and a third metal layer from viewing direction V of Figure 4, wherein the insulating material of the interconnect substrate is not shown.
Figure 7 is a cross sectional view of an example of a semiconductor chip package having a first and a second semiconductor transistor chip and an interconnect substrate disposed between the first and the second semiconductor transistor chip.
Figure 8 is a cross sectional view of an example of a vertical semiconductor chip package having a first and a second semiconductor transistor chip and an interconnect substrate disposed between the first and the second semiconductor transistor chip.
Figure 9 is a cross sectional view of an example of a semiconductor chip package having an interconnect substrate and a first and a second semiconductor transistor chip mounted on the same side of the interconnect substrate.
Figure 10 is a plan bottom view (footprint) on an example of a semiconductor chip package such as, e.g., the semiconductor chip package of Figure 9.
Figure 11 is a flowchart illustrating exemplary stages of a method of manufacturing a semiconductor chip package.

### Detailed description

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

Further, the words "over" or "beneath" with regard to a part, element or material layer formed or located or arranged "over" or "beneath" a surface may be used herein to mean that the part, element or material layer be located (e.g. placed, formed, arranged, deposited, etc.) "directly on" or "directly under", e.g. in direct contact with, the implied surface. The words "over" or "beneath" used with regard to a part, element or material layer formed or located or arranged "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

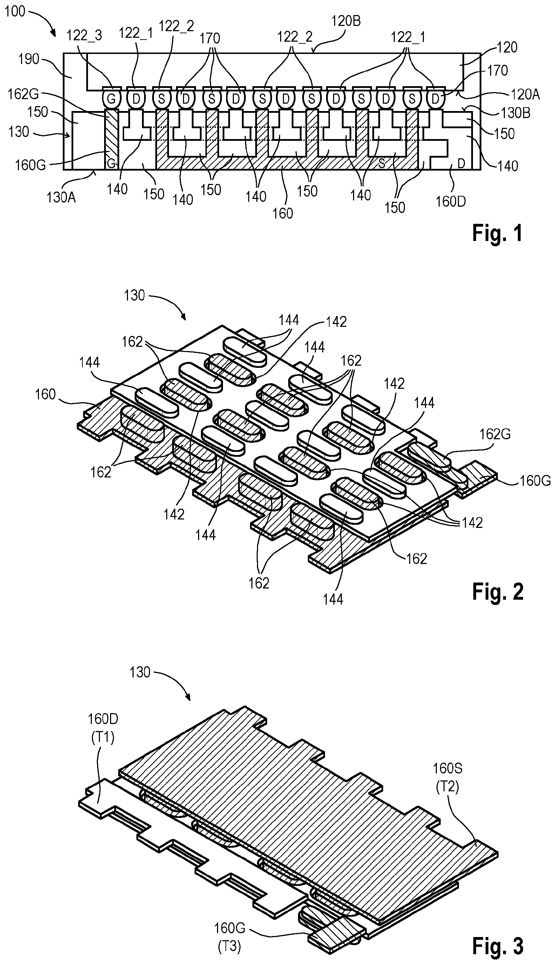

Referring to Figures 1 and 2, a semiconductor chip package 100 includes a semiconductor transistor chip 120. The semiconductor transistor chip 120 has a first side 120A and a second side 120B opposite the first side 120A. The first side 120A includes first load current chip pads 122_1 and second load current chip pads 122_2. Further, a third chip pad 122_3 (e.g., gate (G) pad) may be provided on the first side 120A.

For example, without loss of generality, in the following the first load current chip pads 122_1 are, e.g., the drain (D) chip pads of the semiconductor transistor chip 120 and the second load current chip pads 122_2 are, e.g., the source (S) chip pads of the semiconductor transistor chip 120. However, it is also possible that the first load current chip pads 122_1 may be the source (S) chip pads and the second load current chip pads 122_2 may be the drain (D) chip pads of the semiconductor transistor chip 120.

The semiconductor chip package 100 further includes an interconnect substrate 130. The interconnect substrate 130 includes a first metal layer 140, a second metal layer 160 and an insulating material 150 disposed between the first metal layer 140 and the second metal layer 160.

The first metal layer 140 includes a pattern of holes 142 ("pinhole design"). The second metal layer 160 includes a pattern of protrusions 162 ("nailboard design"). At least some of the protrusions 162 pass through the holes 142.

The first metal layer 140 may be continuous. For example, it may be without any internal structures (e.g., or cutouts, slits, etc.) except the pattern of holes 142.

The protrusions 162 may project over an upper plane of the first metal layer 140. The first metal layer 140 may be provided with a pattern of posts 144 projecting from the upper plane of the first metal layer 140. The posts 144 may project over the upper plane of the first metal layer 140 by about the same height as the protrusions 162 project over the upper plane of the first metal layer 140.

The protrusions 162 of the second metal layer 160 and the posts 144 of the first metal layer 140 may be exposed at an upper side 130B of the interconnect substrate 130.

The semiconductor transistor chip 120 is mounted on the interconnect substrate 130 with the first side 120A facing the upper side 130B of the interconnect substrate 130. The first metal layer 140 is connected to a plurality of the first load current chip pads 122_1 via the posts 144. The second metal layer 160 is connected to a plurality of the second load current chip pads 122_2 via the protrusions 162. A separate (insular) segment 160G of the second metal layer 160 may be connected to the third chip pad 122_3.

In other examples (not shown), the first metal layer 140 may be connected to the source (S) chip pads and the second metal layer 160 may be connected to the drain (D) chip pads of the semiconductor transistor chip 120.

As shown in Figure 1, the insulating material 150 of the interconnect substrate 130 may be formed by a mold compound material, referred to in the following as an interconnect structure mold compound. The interconnect structure mold compound may embed at least partially the first metal layer 140 and the second metal layer 160. The interconnect substrate 130 may thus be a pre-molded part used as a carrier for chip mounting.

The metal layers 140, 160 may, e.g., be plated metal layers, in particular electroplated metal layers 140, 160. For example, the metal layers 140, 160 and the feedthroughs (protrusions 162, posts 144) of the interconnect substrate 130 may be built up additively or semi-additively by electroplating (galvanic plating). Such interconnect substrates 130 using electroplated metal structures and molding for providing the insulating material 150 are also referred to in the art as MIS (molded interconnect substrate) or routable substrate.

In some examples, the insulating material 150 of the pre-formed interconnect substrate 130 may include or be a laminate material. In this case, the interconnect substrate 130 may be a pre-formed part fabricated by a lamination process (without molding) .

In some examples, the insulating material 150 of the pre-formed interconnect substrate 130 may include or be a mold material layer (mold sheet) which is laminated. An exemplary example of a laminated mold sheet is an ABF (Ajinomoto Build-up Film^{®}) material. In this case, the interconnect substrate 130 may be a pre-formed part fabricated by a lamination process and a subsequent curing and/or molding process.

In other examples, the insulating material 150 of the pre-formed interconnect substrate 130 may include or be a ceramic material. In this case, the interconnect substrate 130 may be a pre-formed ceramic-based carrier.

In all examples, the thickness of the first and second metal (Cu) layers 140, 160 may be between 20 and 170 um, in particular 30 and 100 um, for example. In some examples, the thickness of the first and second metal (Cu) layers 140, 160 was equal to (or greater than or less than) 70 µm. The thickness of the layer of insulating material 150 disposed between the first and second metal (Cu) layers 140, 160 may be between 50 and 190 um, for example. In some examples, the thickness of the layer of insulating material 150 was equal to (or greater than or less than) 100 um.

The vertical dimension of the protrusion 162 may be, e.g., equal to or greater than 150 or 175 or 200 or 250 or 300 µm in height or even more, depending, inter alia, on the thickness of the first metal layer 140 and the thickness of the layer of insulating material 150.

The lateral dimensions of the protrusions 162 and/or the posts 144 may be, e.g., about 500 µm in length (along the longitudinal side of the semiconductor chip package 100) and, e.g., about 185 µm in width (along the transversal side of the semiconductor chip package 100), for example. This means that these structures may, e.g., be relatively large. For example, the cross sectional area of each protrusion 162 and/or each post 144 may be equal to or greater than or less than 0.01 or 0.03 or 0.06 or 0.09 or 0.12 mm².

The fist load current chip pads 122_1 may be arranged on the first side 120A of the semiconductor transistor chip 120 in a pattern which is aligned with the pattern of posts 144. The second load current chip pads 122_2 may be arranged on the first side 120A of the semiconductor transistor chip 120 in a pattern which is aligned with the pattern of holes 142 and the pattern of protrusions 162.

That is, a plurality of drain chip pads (D) 122_1 (aligned with posts 144) may be, e.g., arranged in a number of (horizontal) rows parallel to the longitudinal side of the semiconductor transistor chip 120. Likewise, a plurality of source chip pads (S) 122_2 (aligned with holes 142 and protrusions 162) may be arranged in a number of (horizontal) rows parallel to the rows of the drain chip pads (D) 122_1. In the example shown in Figure 2, the rows of drain chip pads (D) 122_1 and the rows of source chip pads (S) 122_2 are, e.g., interleaved or alternating in the transversal (horizontal) direction of the semiconductor transistor chip 120.

Further, the drain chip pads (D) 122_1 and the source chip pads (S) 122_2 may, e.g., be offset from each other in the longitudinal (horizontal) direction (see Figure 2). In other examples, the drain chip pads (D) 122_1 and the source chip pads (S) 122_2 may, e.g., be aligned with each other in the longitudinal (horizontal) direction. The gate chip pad (G) 122_3 may be arranged at a corner of the semiconductor transistor chip 120. It may, e.g., be formed by a single gate pad (G) which is aligned with a gate protrusion 162G of the separate segment 160G of the second metal layer 160.

The (exemplary) layout of first and second load current chip pads 122_1 (D) and 122_2 (S) is re-routed by the package-internal interconnect substrate 130. That is, the interconnect substrate 130 as disclosed herein realizes a package internal areal interconnect for the semiconductor chip connections. This internal areal interconnect feeds and taps current over virtually the whole area of the first metal layer 140 and the second metal layer 160, respectively, to and from the semiconductor transistor chip 120. Due to the alternating source-drain chip pad arrangement of, e.g., a GaN transistor chip, it is otherwise difficult to achieve such a high degree of area utilization for package-internal current transport.

In other words, the interconnect structure 130 disclosed herein offers a maximum conductive cross section of the first metal layer 140 and the second metal layer 160 close to the chip metallization at the first side 120A of the semiconductor transistor chip 120. To this end, an interconnect structure 130 including parallel drain and source layers (i.e., the first and second metal layers 140, 160) is provided. By using such a parallel layer interconnect substrate design, where one of the contacts (e.g., source) is fed through the other contact (e.g., drain) by a "pin-and-hole" concept, an optimum power management can be achieved. This increases the efficiency and performance of the semiconductor transistor package 100, especially for GaN or other WBG devices.

For example, all first load current chip pads 122_1 are connected to one plane (e.g., first metal layer 140) of the interconnect substrate 130, and/or all second load current chip pads 122_2 are connected to another plane (e.g., second metal layer 160) of the interconnect substrate 130. This way, a very low electrical package resistance for the lateral current flow can be achieved.

The interconnect substrate 130 may be connected to the first and second load current chip pads 122_1, 122_2 and, e.g., to the third chip pad 122_3 by bond elements 170. For example, the bond elements 170 may include or be solder balls or Cupillars. Other bond elements 170 conventionally used for flipchip technology, such as, e.g., conductive adhesive, metal paste, or diffusion solder material etc., may also be possible.

The semiconductor transistor chip 120 is, e.g., a power transistor chip. For example, the semiconductor transistor chip 120 may be a horizontal device, in which a main direction of load current flow in the chip is in the horizontal direction. Without loss of generality, the semiconductor transistor chip 120 is described herein to be a GaN chip, for example. However, the disclosure also applies to other chips such as, e.g., Si or SiC chips, which may also provide drain, source and gate chip pads 122_1, 122_2, 122_3 at a first side 120A of the semiconductor transistor chip 120.

Figure 3 is a perspective bottom view (footprint) of the semiconductor chip package 100 of Figures 1 and 2. In this example, the second metal layer 160 is structured to form the package terminals. To this end, the second metal layer 160 may include a separate (insular) segment 160S, a separate (insular) segment 160D and the separate (insular) segment 160G, for example.

A first package load terminal T1 (e.g., drain terminal) is formed by the separate (insular) segment 160D. The separate (insular) segment 160D is connected to the first metal layer 140.

A second package load terminal T2 (e.g., source terminal) is formed by the separate (insular) segment 160S. The separate (insular) segment 160S is provided with the protrusions 162.

A third package terminal T3 (e.g., gate terminal) may be formed by the separate (insular) segment 160G.

The separate segments 160D and/or 160S of the second metal layer 160 may each be continuous. Further, they may be without any internal structure (e.g., slits, cutouts, etc.). That is, the load current can be trapped and bundled over the whole area of each of these segments 160D, 160S.

As illustrated in Figure 3, the first package load terminal T1 (e.g., segment 160D) may extend along one longitudinal side of the semiconductor chip package 100, and the second package load terminal T2 (e.g., segment 160S) may extend along an opposite longitudinal side of the semiconductor chip package 100. The third package terminal T3 (e.g., segment 160G) may be arranged next to the first package load terminal T1, for example.

The semiconductor chip package 100 may, e.g., further include a package mold compound body 190. The (optional) package mold compound body 190 may embed the semiconductor transistor chip 120 and the interconnect substrate 130. The package mold compound body 190 may cover the second side 120B of the semiconductor transistor chip 120 or may leave the second side 120B of the semiconductor transistor chip 120 exposed (see, e.g., Figure 1). For example, the semiconductor chip package 100 may be a top side cooling (TSC) package.

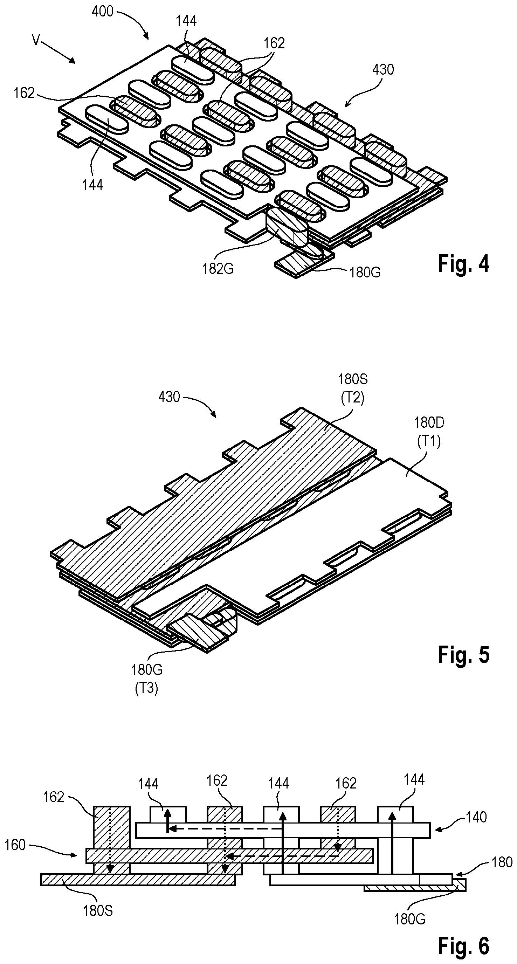

Figures 4 to 6 illustrate an example of a semiconductor chip package 400. Only the metal layer design of the interconnect substrate 430 of the semiconductor package 400 is shown. Additional features of the semiconductor chip package 400 may be similar or identical as described above for semiconductor chip package 100.

The interconnect substrate 430 includes a first metal layer 140, a second metal layer 160 and a third metal layer 180. As described above, an insulating material 150 (not shown), which can be of various different types, is disposed between and may embed the first, second and third metal layers 140, 160, 180.

The first metal layer 140 and/or the second metal layer 160 may be designed as areal load current layers in accordance with the "pin-and-hole" concept presented above, and reference is made to the above description to avoid reiteration.

In the example of semiconductor chip package 400, the third metal layer 180 is structured to form the package terminals. To this end, the third metal layer 180 may include a separate (insular) segment 180S, a separate (insular) segment 180D and the separate (insular) segment 180G, for example (see Figure 5). The third metal layer 180 may also be referred to as a terminal metal layer.

A first package load terminal T1 (e.g., drain terminal) is formed by the separate (insular) segment 180D. The separate (insular) segment 180D may be connected to the first metal layer 140 (see Figure 6).

A second package load terminal T2 (e.g., source terminal) is formed by the separate (insular) segment 180S. The separate (insular) segment 180S may be connected to the second metal layer 160 (see Figure 6).

A third package terminal T3 (e.g., gate terminal) is formed by the separate (insular) segment 180G. The separate (insular) segment 180G may be connected to the third chip pad 122_3 by a gate protrusion 182G which, e.g., bypasses the first and second metal layers 140, 160.

The separate segments 180D and/or 180S of the third metal layer 180 may each be continuous. They may extend along opposite longitudinal sides of the semiconductor chip package 400.

In comparison with the two layer approach (Figures 1 to 3), the three layer approach offers a higher variability of footprint design (for example, the separate segments 180D and 180S (i.e., the package terminals T1, T2) may be of similar size). Further, the device specifications in terms of the electrical resistance of the package and the package parasitics (inductance) may be improved by adding the third metal layer 180.

The arrows in Figure 6 illustrate contributions of the various currents flows in the interconnect substrate 430 to the package inductance. The inductances caused by the current flow in (solid arrow) and out (dotted arrow) of the interconnect substrate 430 cancel from each other. The main contribution to the package inductance is caused by the lateral currents flow along the dashed arrows. However, as these current flows are along the short edge (width) of the semiconductor chip package 400, this contribution is also not significant. As a result, very low package parasitics (inductances) can be obtained.

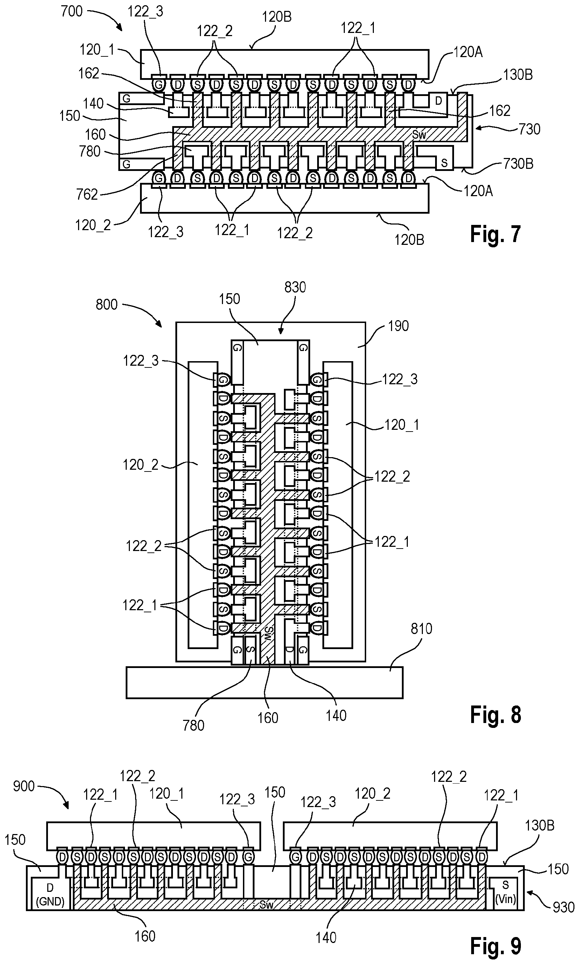

Figure 7 illustrates of an example of a semiconductor chip package 700. The semiconductor chip package 700 includes a first semiconductor transistor chip 120_1, a second semiconductor transistor chip 120_2 and an interconnect substrate 730 disposed between the first and the second semiconductor transistor chips 120_1, 120_2.

The first semiconductor transistor chip 120_1 may be identical with the semiconductor transistor chip 120 described above. The second semiconductor transistor chip 120_2 may (likewise) have a first side 120A and a second 120B side opposite the first side. The first side 120A includes first load current chip pads 122_1 and second load current chip pads 122_2. The second semiconductor transistor chip 120_2 may be designed as described for the semiconductor transistor chip 120. For example, it may be of the same type and/or identical with the first second semiconductor transistor chip 120_1.

The interconnect substrate 730 includes the first metal layer 140 as described above. It further includes the second metal layer 160 which may, e.g., be designed in relation to the first semiconductor transistor chip 120_1 as described with reference to Figures 1 to 3.

Further, the interconnect substrate 730 includes a third metal layer 780 and insulating material 150 disposed between the first metal layer 140, the second metal layer 160 and the third metal layer 780.

The second semiconductor transistor chip 120_2 is mounted on the interconnect substrate 730 with its first side 120A facing a lower side 730B of the interconnect substrate 730 opposite the upper side 130B on which the first semiconductor transistor chip 120_1 is mounted.

The second metal layer 160 may be connected to a plurality of the first load current chip pads 122_1 (D) of the second semiconductor transistor chip 120_2 and the third metal layer 780 may be connected to a plurality of the second load current chip pads 122_2 (S) of the second semiconductor transistor chip 120_2.

In other words, in terms of the "pin-and-hole" concept, the second semiconductor transistor chip 120_2 may be connected to the interconnect substrate 730 the same way as the first semiconductor transistor chip 120_1 (corresponding to semiconductor transistor chip 120) is connected to the interconnect substrate 730 (corresponding to interconnect substrate 130). Therefore, the same package benefits are obtained for the connection of both semiconductor transistor chips 120_1, 120_2. Further, the second metal layer 160 may be a "shared" metal layer, i.e. may connect via the protrusions ("pins") 162 and corresponding protrusions ("pins") 762 to the first and second semiconductor transistor chips 120_1 and 120_2, respectively.

That is, the same basic interconnect substrate design as described with reference to Figures 1 to 3 is used, with an additional third metal layer 780 to realize a double side assembly. The double side assembly can be used as a half-bridge or full-bridge device, for example.

For example, Figure 7 illustrates a half-bridge circuitry in which the second metal layer 160 is used for the switch (Sw) terminal, the first metal layer 140 is used for the drain (D) terminal and the third metal layer 780 is used for the source (S) terminal. In this specific example, the first semiconductor transistor chip 120_1 is the high-sider and the second semiconductor transistor chip 120_2 is the low-sider of the half-bridge circuitry. However, this can be interchanged depending on the routing in the interconnect substrate 730.

Further, the double side assembly approach can be used for semiconductor chip packages 700 including multiple semiconductor transistor chips 120_1, 120_2 which are connected to form circuits different than half-bridge or full-bridge circuitry. For example, the semiconductor transistor chips 120_1, 120_2 may be connected in parallel.

Generally, the semiconductor chip packages 100, 400, 700 shown in Figure 1, Figure 4 and Figure 7 may be used as inlays for further embedding technologies or may be used directly as semiconductor chip packages for, e.g., discrete devices or modules. In particular in the latter case, the semiconductor chip package 100, 400, 700 may, e.g., further include a package mold compound body 190 as exemplarily shown in Figure 1.

Figure 8 illustrates an example of a semiconductor chip package 800 having a first and a second semiconductor transistor chip 120_1, 120_2 and an interconnect substrate 830 disposed between the first and the second semiconductor transistor chip 120_1, 120_2. The semiconductor chip package 800 is similar to the semiconductor chip package 700, and reference is made to the above description to avoid reiteration.

The semiconductor chip package 800 is configured to be attached to an application board 810 with the interconnect substrate 830 being arranged in an inclined, in particular vertical orientation relative to the application board 810.

That is, the semiconductor transistor chips 120_1, 120_2 are inclined, in particular vertical relative to the application board 810. In other words, the semiconductor chip package 800 is a "vertical" chip package.

The drain package load terminal (D), the source package load terminal (S), optionally the switch package terminal (Sw) and one or more gate package terminals (G) are exposed at the footprint side of the package mold compound body 190.

Similar as the semiconductor chip package 700 which is used (with slight adaptions at the footprint side) for the vertical semiconductor package 800, also the single chip semiconductor chip packages 100, 400 may be re-designed as vertical chip packages. Vertical chip packages allow a reduction of the footprint area. In particular, the footprint design of a vertical semiconductor chip package is no longer limited by the size and/or the pad layout of the semiconductor transistor chip(s) 120, 120_1, 120_2.

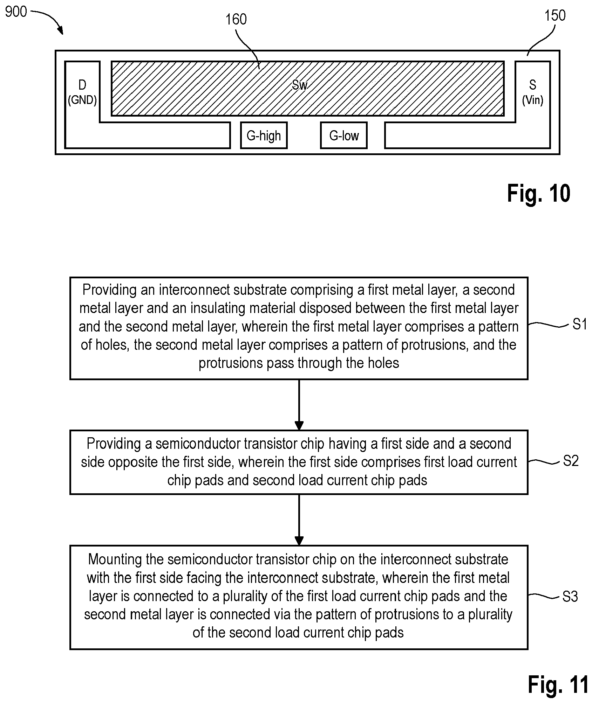

Figure 9 (sectional view) and Figure 10 (footprint) illustrate an example of a semiconductor chip package 900. The semiconductor chip package 900 has an interconnect substrate 930. A first and a second semiconductor transistor chip 120_1, 120_2 are mounted on the same upper side 130B of the interconnect substrate 930.

Figure 9 illustrates an example how a side-by-side integration of multiple semiconductor transistor chips 120_1, 120_2 may, e.g., be implemented on an interconnect substrate featuring the "pin-and-hole" design concept described above. In the specific example shown, the interconnect substrate 930 is a two metal layer substrate as described in connection with Figures 1 to 3. However, the side-by-side arrangement of multiple semiconductor transistor chips 120_1, 120_2 may analogously be implemented on any other interconnect substrate 430, 730, 830. Further, the interconnect circuitry provided by the interconnect substrate 930 is a mere example and can be modified as desired.

Figure 10 illustrates an exemplary footprint layout of the semiconductor chip package 900. For example, the first semiconductor transistor chip 120_1 may, e.g., be the high-sider of the half-bride circuitry and the second semiconductor transistor chip 120_2 may, e.g., be the low-sider of the half-bride circuitry. The ground terminal (GND) of the semiconductor chip package 900 may, e.g., be connected to the first load current chip pads 122_1 (D) of the first semiconductor transistor chip 120_1, and the voltage terminal (Vin) may be connected to the second load current chip pads 122_2 (S) of the second semiconductor transistor chip 120_2.

In all semiconductor chip packages disclosed herein, it is possible to additionally implement further electronic devices such as, e.g., one or more driver chips and/or passive components.

Figure 11 illustrates exemplary stages of a method of manufacturing a semiconductor chip package. At S1, an interconnect substrate comprising a first metal layer, a second metal layer and an insulating material disposed between the first metal layer and the second metal layer is provided. The first metal layer comprises a pattern of holes, the second metal layer comprises a pattern of protrusions, and the protrusions pass through the holes.

As mentioned before, the interconnect substrate may be provided by forming the second metal layer and the protrusions by electroplating. Further, the first metal layer may be formed by electroplating. The insulating material of the interconnect substrate may be formed, e.g., by molding or may be provided as a laminate material or as a ceramic material.

At S2, a semiconductor transistor chip having a first side and a second side opposite the first side is provided. The first side comprises first load current chip pads and second load current chip pads.

At S3, the semiconductor transistor chip is mounted on the interconnect substrate with the first side facing the interconnect substrate. The first metal layer is connected to a plurality of the first load current chip pads and the second metal layer is connected via the pattern of protrusions to a plurality of the second load current chip pads.

Then, forming the semiconductor chip package may further comprise embedding the interconnect substrate and the semiconductor transistor chip in a package mold compound body.

In all examples disclosed herein, the semiconductor transistor chip(s) 120, 120_1, 120_2 may be, e.g., capable of switching high currents and/or medium voltages or high voltages (e.g., more than 50 V or 100 V or 200 V or 300 V or 400 V or 500 V blocking voltage). In particular, exemplary semiconductor chip packages as disclosed herein may operate in the medium voltage (MV) range, in which the blocking voltage is equal to or greater than or less than 200 V or 150 V or 100 V or 50 V.

The (power) transistor chips 120, 120_1, 120_2 may be of different types. Examples described herein are, in particular, directed to HEMT (high electron mobility transistor) devices, for example. The semiconductor transistor chip(s) 120, 120_1, 120_2 disclosed herein may, e.g., be III-V compound semiconductor chip(s) having, e.g., a wide band gap. The semiconductor transistor chip 120, 120_1, 120_2 may, e.g., be a GaN chip, including lateral GaN-on-substrate devices such as a GaN-on-Si device or a GaN-on-SiC device or a GaN-on-sapphire device or a GaN-on-diamond device, for example. Further, the semiconductor transistor chip 120, 120_1, 120_2 may, e.g., be a Si-chip or a SiC chip.

### EXAMPLES

The following examples pertain to further aspects of the disclosure:
Example 1 is a semiconductor chip package. The semiconductor chip package includes a semiconductor transistor chip having a first side and a second side opposite the first side. The first side includes first load current chip pads and second load current chip pads. An interconnect substrate comprises a first metal layer, a second metal layer and an insulating material disposed between the first metal layer and the second metal layer. The first metal layer includes a pattern of holes, the second metal layer includes a pattern of protrusions, and the protrusions pass through the holes. The semiconductor transistor chip is mounted on the interconnect substrate with the first side facing the interconnect substrate. The first metal layer is connected to a plurality of the first load current chip pads and the second metal layer is connected via the pattern of protrusions to a plurality of the second load current chip pads.
In Example 2, the subject matter of Example 1 can optionally include wherein the second load current chip pads are arranged in a pattern which is aligned with the pattern of holes and the pattern of protrusions.
In Example 3, the subject matter of Example 1 or 2 can optionally include wherein the insulating material is part of an interconnect structure mold compound embedding at least partially the first metal layer and the second metal layer, or the insulating material is a laminate, or the insulating material is a ceramic.
In Example 4, the subject matter of any of the preceding Examples can optionally include wherein the first metal layer comprises a plated metal layer, in particular an electroplated metal layer and/or wherein the second metal layer comprises a plated metal layer, in particular an electroplated metal layer.
In Example 5, the subject matter of any of the preceding Examples can optionally include wherein the semiconductor transistor chip is a power chip, in particular a GaN transistor chip or a Si transistor chip or a SiC transistor chip.
In Example 6, the subject matter of any of the preceding Examples can optionally further include a further semiconductor transistor chip having a first side and a second side opposite the first side, wherein the first side comprises first load current chip pads and second load current chip pads, wherein the interconnect substrate further comprises: a third metal layer and insulating material disposed between the third metal layer and the second metal layer, wherein the further semiconductor transistor chip is mounted on the interconnect substrate with its first side facing a side of the interconnect substrate opposite the side on which the semiconductor transistor chip is mounted, and the third metal layer is connected to a plurality of the second or first load current chip pads of the further semiconductor transistor chip and the second metal layer is connected to a plurality of the first or second load current chip pads of the further semiconductor transistor chip, respectively.
In Example 7, the subject matter of any of the preceding Examples can optionally include wherein the semiconductor chip package is configured to be attached to an application board with the interconnect substrate being arranged in an inclined, in particular vertical orientation relative to the application board.
In Example 8, the subject matter of any of Examples 1 to 5 can optionally further include a semiconductor transistor chip having a first side and a second side opposite the first side, wherein the first side comprises first load current chip pads and second load current chip pads, wherein the further semiconductor transistor chip is mounted on the interconnect substrate with its first side facing a side of the interconnect substrate which is the same side on which the first semiconductor transistor chip is mounted, wherein the first metal layer comprises a further pattern of holes, the second metal layer comprises a further pattern of protrusions, and the protrusions of the further pattern of protrusions pass through the holes of the further pattern of holes, and the first metal layer is connected to a plurality of the second or first load current chip pads of the further semiconductor transistor chip and the second metal layer is connected via the further pattern of protrusions to a plurality of the first or second load current chip pads of the further semiconductor transistor chip, respectively.
In Example 9, the subject matter of any of Examples 6 to 8 can optionally include wherein the semiconductor package comprises a half-bridge or full-bridge circuitry.
In Example 10, the subject matter of any of Examples 1 to 5 or 8 can optionally further include a terminal metal layer and insulating material disposed between the second metal layer and the terminal metal layer, wherein the terminal metal layer is structured to comprise a first segment and a second segment, wherein the first segment is connected to the first metal layer and the second segment is connected to the second metal layer, wherein the first segment and the second segment form load current terminals of the semiconductor chip package.
Example 11 is a method of manufacturing a semiconductor chip package. The method comprises providing an interconnect substrate comprising a first metal layer, a second metal layer and an insulating material disposed between the first metal layer and the second metal layer. The first metal layer includes a pattern of holes, the second metal layer includes a pattern of protrusions, and the protrusions pass through the holes. The method comprises providing a semiconductor transistor chip having a first side and a second side opposite the first side, wherein the first side comprises first load current chip pads and second load current chip pads. The method further comprises mounting the semiconductor transistor chip on the interconnect substrate with the first side facing the interconnect substrate, wherein the first metal layer is connected to a plurality of the first load current chip pads and the second metal layer is connected via the pattern of protrusions to a plurality of the second load current chip pads.
In Example 12, the subject matter of Example 11 can optionally further include wherein providing the interconnect substrate comprises forming the second metal layer and the protrusions by electroplating.
In Example 13, the subject matter of Examples 11 or 12 can optionally further include wherein providing the interconnect substrate comprises forming the first metal layer by electroplating.
In Example 14, the subject matter of any of Examples 11 to 13 can optionally further include wherein providing the interconnect substrate comprises forming the insulating material by molding, or providing the insulating material as a laminate material.
In Example 15, the subject matter of any of Examples 11 to 14 can optionally further include wherein forming the semiconductor chip package further comprises embedding the interconnect substrate and the semiconductor transistor chip in a package mold compound.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor chip package, comprising:
a semiconductor transistor chip having a first side and a second side opposite the first side, wherein the first side comprises first load current chip pads and second load current chip pads; and
an interconnect substrate comprising a first metal layer, a second metal layer and an insulating material disposed between the first metal layer and the second metal layer, wherein the first metal layer comprises a pattern of holes, the second metal layer comprises a pattern of protrusions, and the protrusions pass through the holes; wherein
the semiconductor transistor chip is mounted on the interconnect substrate with the first side facing the interconnect substrate, and
the first metal layer is connected to a plurality of the first load current chip pads and the second metal layer is connected via the pattern of protrusions to a plurality of the second load current chip pads.

2. The semiconductor chip package of claim 1, wherein the second load current chip pads are arranged in a pattern which is aligned with the pattern of holes and the pattern of protrusions.

3. The semiconductor chip package of claim 1 or 2, wherein
the insulating material is part of an interconnect structure mold compound embedding at least partially the first metal layer and the second metal layer, or
the insulating material is a laminate, or
the insulating material is a ceramic.

4. The semiconductor chip package of any of the preceding claims, wherein the first metal layer comprises a plated metal layer, in particular an electroplated metal layer and/or wherein the second metal layer comprises a plated metal layer, in particular an electroplated metal layer.

5. The semiconductor chip package of any of the preceding claims, wherein the semiconductor transistor chip is a power chip, in particular a GaN transistor chip or a Si transistor chip or a SiC transistor chip.

6. The semiconductor chip package of any of the preceding claims, further comprising:
a further semiconductor transistor chip having a first side and a second side opposite the first side, wherein the first side comprises first load current chip pads and second load current chip pads, wherein the interconnect substrate further comprises:
a third metal layer and insulating material disposed between the third metal layer and the second metal layer, wherein
the further semiconductor transistor chip is mounted on the interconnect substrate with its first side facing a side of the interconnect substrate opposite the side on which the semiconductor transistor chip is mounted, and
the third metal layer is connected to a plurality of the second or first load current chip pads of the further semiconductor transistor chip and the second metal layer is connected to a plurality of the first or second load current chip pads of the further semiconductor transistor chip, respectively.

7. The semiconductor chip package of any of the preceding claims, wherein the semiconductor chip package is configured to be attached to an application board with the interconnect substrate being arranged in an inclined, in particular vertical orientation relative to the application board.

8. The semiconductor chip package of any of claims 1 to 5, further comprising:
a further semiconductor transistor chip having a first side and a second side opposite the first side, wherein the first side comprises first load current chip pads and second load current chip pads, wherein
the further semiconductor transistor chip is mounted on the interconnect substrate with its first side facing a side of the interconnect substrate which is the same side on which the first semiconductor transistor chip is mounted,
wherein the first metal layer comprises a further pattern of holes, the second metal layer comprises a further pattern of protrusions, and the protrusions of the further pattern of protrusions pass through the holes of the further pattern of holes, and
the first metal layer is connected to a plurality of the second or first load current chip pads of the further semiconductor transistor chip and the second metal layer is connected via the further pattern of protrusions to a plurality of the first or second load current chip pads of the further semiconductor transistor chip, respectively.

9. The semiconductor chip package of any of claims 6 to 8, wherein the semiconductor package comprises a half-bridge or full-bridge circuitry.

10. The semiconductor chip package of any of claims 1 to 5 or 8, wherein the interconnect substrate further comprises:
a terminal metal layer and
insulating material disposed between the second metal layer and the terminal metal layer, wherein
the terminal metal layer is structured to comprise a first segment and a second segment, wherein the first segment is connected to the first metal layer and the second segment is connected to the second metal layer, wherein the first segment and the second segment form load current terminals of the semiconductor chip package.

11. A method of manufacturing a semiconductor chip package, comprising:
providing an interconnect substrate comprising a first metal layer, a second metal layer and an insulating material disposed between the first metal layer and the second metal layer, wherein the first metal layer comprises a pattern of holes, the second metal layer comprises a pattern of protrusions, and the protrusions pass through the holes;
providing a semiconductor transistor chip having a first side and a second side opposite the first side, wherein the first side comprises first load current chip pads and second load current chip pads; and
mounting the semiconductor transistor chip on the interconnect substrate with the first side facing the interconnect substrate, wherein the first metal layer is connected to a plurality of the first load current chip pads and the second metal layer is connected via the pattern of protrusions to a plurality of the second load current chip pads.

12. The method of claim 11, wherein providing the interconnect substrate comprises:
forming the second metal layer and the protrusions by electroplating.

13. The method of claim 11 or 12, wherein providing the interconnect substrate comprises:
forming the first metal layer by electroplating.

14. The method of any of claims 11 to 13, wherein providing the interconnect substrate comprises:
forming the insulating material by molding, or
providing the insulating material as a laminate material.

15. The method of any of claims 11 to 14, wherein forming the semiconductor chip package further comprises:
embedding the interconnect substrate and the semiconductor transistor chip in a package mold compound.
